(19) Europäisches Patentamt
European Patent Office
Office européen des brevets

(11) EP 3 620 946 A1

(12) EUROPÄISCHE PATENTANMELDUNG

(43) Veröffentlichungstag:
11.03.2020 Patentblatt 2020/11

(51) Int Cl.:
*G06F 30/28* (2020.01)

(21) Anmeldenummer: 19195130.0

(22) Anmeldetag: 03.09.2019

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: 04.09.2018 DE 102018121519

(71) Anmelder: **Deutsches Zentrum für Luft- und Raumfahrt e.V.**
**51147 Köln (DE)**

(72) Erfinder: **RAICHLE, Axel**
**38112 Braunschweig (DE)**

(74) Vertreter: **Gramm, Lins & Partner**
**Patent- und Rechtsanwälte PartGmbB**
**Freundallee 13a**
**30173 Hannover (DE)**

(54) **VERFAHREN UND VORRICHTUNG ZUM NUMERISCHEN MESSEN MINDESTENS EINER STRÖMUNGSBEZOGENEN EIGENSCHAFT**

(57) Die Erfindung betrifft ein Verfahren zum numerischen Messen mindestens einer strömungsbezogenen Eigenschaft eines Profilschnittes eines rotierenden, fluidumströmbaren Profilkörpers mittels einer auf einer Datenverarbeitungsanlage ablaufenden numerischen Strömungssimulation, die eine fluidbasierte Umströmung des Profilsschnittes mittels mehrdimensionaler Rechennetze berechnet, wobei das Verfahren die folgenden Schritte umfasst:

- Bereitstellen einer auf einer Datenverarbeitungsanlage ausführbaren numerischen Strömungssimulation, die derart eingerichtet ist, dass

◦ die Strömungsgeschwindigkeit des Fernfeldes der numerischen Strömungssimulation auf null gesetzt ist und stattdessen eine Gitterbewegung des mehrdimensionalen Rechennetzes mit einer Translationsgeschwindigkeit in der Profilschnittebene ausgeführt wird, so dass die Relativgeschwindigkeit die Anströmgeschwindigkeit des Profilschnittes unter einem gegebenen Anstellwinkel ergibt,

◦ die Symmetrierandbedingungen für die Ränder des mehrdimensionalen Rechennetzes auf eine translatorisch periodische Randbedingung gesetzt sind, und

◦ in den Trägheitstermen der Bilanzgleichungen der numerischen Strömungssimulation die aus dem Geschwindigkeitsfeld der Drehbewegung auf dem Rand des Profilschnittes resultierende Geschwindigkeitskomponente in Normalenrichtung der Profilschnittebene berücksichtigt werden,

- Ausführen der wie zuvor bereitgestellten numerischen Strömungssimulation, um die mindestens eine strömungsbezogene Eigenschaft des Profilschnittes numerisch zu messen und zu erhalten.

Figur 3

**Beschreibung**

Die Erfindung betrifft ein Verfahren, eine Vorrichtung und ein Computerprogramm zum numerischen Messen mindestens einer strömungsbezogenen Eigenschaft eines Profilschnittes eines rotierenden, fluidumströmbaren Profilkörpers mittels einer auf einer Datenverarbeitungsanlage ablaufenden numerischen Strömungssimulation, die eine fluidbasierte Umströmung des Profilschnittes mittels mehrdimensionaler Rechennetze berechnet.

Die Form von rotierenden, fluidumströmbaren Profilkörpern wie beispielsweise Propeller, Rottorblätter, Impeller oder Repeller aber auch Schiffsschrauben, sind aus Profilen in Schnittebenen (kurz: Profilschnitte) senkrecht zu der Profilkörperachse (Erstreckung in Spannweite) aufgebaut, deren strömungsbezogene Eigenschaften (aerodynamische Eigenschaften oder hydrodynamische Eigenschaften) die des Profilkörpers bestimmen. Erst in einem nachgelagerten Entwicklungsschritt erfolgt ggf. eine Gesamtoptimierung des Profilkörpers insgesamt, die umso bessere Ergebnisse liefert, je kleiner die Abweichungen der Ausgangsform von der optimalen Form sind.

In Himmelskamp, H.: "Profile investigations on a Rotating Airscrew", Reports and Translations No 832, AVA 45 A 20, Aerodynamische Versuchsanstalt, Göttingen, 1947 wurde durch die Messung von Auftriebs- und Widerstandskurven an einem rotierenden Impellerblatt, das in konzentrischen Schnitten mit Druckbohrungen versehen war, gezeigt, das rotierende Profilkörper einen sehr viel höheren maximalen Auftrieb, bei einem sehr viel höheren maximalen Anstellwinkel einer anliegenden Strömung erreichen, als dies bei einer Parallelanströmung der Fall ist.

Dem Bericht zufolge wurden ähnliche Beobachtungen zuvor auch schon bei anderen Experimenten gemacht. Als Ursache für diese Eigenschaft werden Trägheitseffekte in der Grenzschicht angesehen. Aus dem Bericht geht nicht hervor, wie ein Verfahren für die Berücksichtigung des Einflusses der Rotation aussehen könnte.

Die Bestimmung der Auftriebs- und Widerstandskurven von rotierenden Blattschnitten in einem Windkanalexperiment erfordert einen hohen Aufwand an Messtechnik und stößt auf das strömungsphysikalische Problem, dass für die Bestimmung der Profileigenschaften eines Profilschnittes keine Änderung der Auftriebsverteilung senkrecht zu der Profilebene vorhanden sein darf. Nach dem Prandtl'schen Wirbelmodell eines Tragflügels verursacht eine Änderung der Auftriebsverteilung in Spannweitenrichtung abgehenden Wirbel, die in der Profilebene eine Strömungsgeschwindigkeit induzieren, wodurch sich die Anströmgeschwindigkeit des Profils und der Anstellwinkel der Profilsehne gegenüber dem Vektor der Anströmgeschwindigkeit ändern, sodass die Auftriebs- und Widerstandskurven einen anderen Verlauf besitzen. Da die induzierten Geschwindigkeiten des Nachlaufs von der Anwendung des Profils abhängen, ist der Einfluss dieses Effektes für die Bestimmung der Profileigenschaften unerwünscht. Die Form und der Einfluss des Wirbelmodells im Nachlauf werden bei dem Entwurf einer tragenden Fläche aus den Profileigenschaften mit Hilfe von analytischen Beziehungen und numerischen Verfahren der Potenzialtheorie bestimmt.

Für die Windkanalmessung bleibt offen, wie der effektive Anstellwinkel ohne Modellannahme für einen rotierenden Blattschnitt bestimmt werden kann, sodass eine gemessene Auftriebs- und Widerstandskurve der Auftriebs- und Widerstandskurve eines Flügels unendlicher Streckung entspricht. Über einen theoretischen Zugang für die Behandlung von Rotationseffekten wird in dem Bericht von H. Himmelskamp beschrieben, das angesichts der Schwierigkeiten, welche die rechnerische Erfassung ebener Grenzschichtvorgänge bereitete, ein solcher Versuch für eine komplexe räumliche Grenzschichtströmung vorerst keine für die Praxis verwertbare Resultate verspreche.

Bei dem Entwurf oder der Nachrechnung von Profilen für rotierende Profilkörper wird der Einfluss der Rotation nicht oder nur heuristisch berücksichtigt. Die strömungsbezogenen Eigenschaften eines Profils bzw. Profilschnittes können unter dem Einfluss der Rotation erheblich von den berechneten oder den gemessenen Eigenschaften ohne den Einfluss der Rotation abweichen und der optimale Betriebspunkt verändert sich. Dies kann dazu führen, dass als Entwurfsgrundlage Profileigenschaften verwendet werden, die nicht den physikalischen Gegebenheiten entsprechen. Bei der Optimierung eines Profilschnittes kann sich eine Form ergeben, die unter den gegebenen Randbedingungen nicht der optimalen Form entspricht.

Mit der Entwicklung der Computer hat sich jedoch die numerische Strömungssimulation entwickelt, der eine direkte Lösung des Systems der Bilanzgleichungen der Strömungsmechanik zugrunde liegt. Da in den Bilanzgleichungen Reibungseffekte und Rotationsbewegungen mathematisch beschrieben werden können, eröffnet sich ein Zugang für die Behandlung des Einflusses der Rotation auf eine ebene Profilumströmung.

Bei der numerischen Strömungssimulation wird dabei ein mehrdimensionales Rechennetz, bspw. ein zweidimensionales Rechennetz oder in einem numerischen Strömungslöser für dreidimensionale Strömungen ein extrudiertes zweidimensionales Rechennetz, verwendet, um den Einfluss des Profilschnittes auf die Anströmung zu simulieren. Der naheliegende Ansatz für eine Berücksichtigung des Einflusses der Rotation, ein zweidimensionales Rechennetz oder ein extrudiertes zweidimensionales Rechennetz zu rotieren, führt jedoch nicht zum Erfolg. Initialisiert man das Geschwindigkeitsfeld einer Drehung um eine Drehachse, die einen endlichen Abstand zu der Netzebene besitzt, entstehen Gittergeschwindigkeiten, die mit zunehmendem Abstand von der Drehachse immer größer werden und deren Komponente senkrecht zu der Netzebene im Verhältnis zu der Komponente in der Netzebene anteilig immer weiter wächst. Bei den hohen Drehraten eines Profilkörpers (bspw. ein Propeller oder ein Rotorblatt) in Verbindung mit einem großen Abstand des Fernfeldrandes von dem Profilschnitt bei einem zweidimensionalen Rechennetz entstehen Gittergeschwindigkeiten, die im Überschall liegen und nahezu senkrecht auf der Netzebene stehen. Dies führt dazu, dass eine Rechnung nicht mehr konvergiert.

Es ist daher Aufgabe der vorliegenden Erfindung ein verbessertes Verfahren sowie eine verbesserte numerische Strömungssimulation anzugeben, mit dem sich ein oder mehrere strömungsbezogene Eigenschaften, insbesondere Auftriebs- und Widerstandkurven von Profilschnitten eines rotierenden, fluidumströmbaren Profilkörpers unter dem Einfluss der Rotation berechnen lassen.. Es ist demzufolge Aufgabe der Erfindung, die Rotation bei der Ermittlung von strömungsbezogenen Eigenschaften von Profilschnitten mit zu berücksichtigen, deren Genauigkeit dazu geeignet ist, den Profilkörper in einem anschließendem Optimierungsschritt gesamtheitlich zu optimieren.

Die Aufgabe wird mit dem Verfahren gemäß Anspruch 1, der Messvorrichtung gemäß Anspruch 9 sowie dem Computerprogramm gemäß Anspruch 11 erfindungsgemäß gelöst.

Gemäß Anspruch 1 wird ein Verfahren zum numerischen Messen mindestens einer strömungsbezogenen Eigenschaft eines Profilschnittes eines rotierenden, fluidumströmbaren Profilkörpers mittels einer auf einer Datenverarbeitungsanlage ablaufenden numerischen Strömungssimulation beansprucht, wobei die numerische Strömungssimulation eine fluidbasierte (aerodynamische oder hydrodynamische) Umströmung des Profilschnittes mittels mehrdimensionaler Rechennetze berechnet und dabei die Rotation des Profilkörpers bzw. des Profilschnittes berücksichtigt. Dabei wird die auf einer Datenverarbeitungsanlage ausführbare numerische Strömungssimulation derart eingerichtet, dass die Strömungsgeschwindigkeit des Fernfeldes der numerischen Strömungssimulation auf null gesetzt ist und stattdessen eine Gitterbewegung des mehrdimensionalen Rechennetzes mit einer Translationsgeschwindigkeit in der Profilschnittebene ausgeführt wird, sodass die Relativgeschwindigkeit die Anströmgeschwindigkeit des Profilschnittes unter einem gegebenen Anstellwinkel ergibt, dass die Symmetriebedingungen für die Ränder des mehrdimensionalen Rechennetzes auf eine translatorisch periodische Randbedingung gesetzt sind, und dass in den Trägheitsthermen der Bilanzgleichungen der numerischen Strömungssimulation die aus dem Geschwindigkeitsfeld der Drehbewegung auf dem Rand des Profilschnittes resultierende Geschwindigkeitskomponente in normalen Richtung der Profilschnittebene berücksichtigt werden. Die so eingerichtete numerische Strömungssimulation wird sodann unter Kenntnis des Profilschnittes ausgeführt, sodass sich die strömungsbezogenen Eigenschaften des Profilschnittes anhand der numerischen Strömungssimulation berechnen lassen. Dabei können bei der Ausführung der numerischen Strömungssimulation verschiedene Einstellwinkel gegenüber der Strömungsrichtung des Fernfeldes berücksichtigt werden, sodass sich hieraus beispielsweise Auftriebs- und Widerstandskurven für den jeweiligen Profilschnitt ergeben. Dabei werden alle Trägheitsterme der Bilanzgleichungen für reibungsbehaftete dreidimensionale Strömungen (bspw. Navier-Strokes-Gleichungen) in der Formulierung für rotierende Rechennetze für die Bilanzgleichungen reibungsfreier Strömungen für die Berechnung einer ebenen fluidbasierten Umströmung eines rotierenden Profilschnittes mit einem nicht rotierenden mehrdimensionalen Rechennetz in der numerischen Strömungssimulation verwenden, wobei die Komponenten der Trägheitskräfte in der Schnittebene, die sich aus dem der Drehbewegung des Randes des Profilschnittes resultierenden Geschwindigkeitsfeld der Strömung in Normalenrichtung der Schnittebene ergeben, für den Einfluss der Rotation wesentlich sind.

Für die Berechnung der Fluidströmung in der Schnittebene eines rotierenden Profilschnittes in einem nicht rotierenden Rechennetz, bei der Trägheitskräfte bisher unberücksichtigt bleiben, werden die aus dem Geschwindigkeitsfeld der Drehbewegung des Randes des Profilschnittes resultierenden Geschwindigkeitskomponenten in Normalenrichtung der Schnittebene sowie aller Trägheitsterme für die Berechnung einer dreidimensionalen Strömuing um einen rotierenden Profilkörper berücksichtigt. Dabei werden die aus dem Geschwindigkeitsfeld der Drehbewegung aus dem Rand des Profilschnittes resultierenden Geschwindigkeitskomponenten in Normalenrichtung der Netzebene berücksichtigt werden und die Trägheitsterme für ein rotierendes Rechennetz in einer stationären Rechnung verwendet.

Der erfindungsgemäße Ansatz für eine Berücksichtigung des Einflusses der Rotation besteht darin, dass in den Trägheitsthermen der Bilanzgleichungen die Komponenten der Strömungsgeschwindigkeit eingehen und nicht die Gittergeschwindigkeit der Rotation. Die Haftbedingung für eine viskose Strömung in dem Modell der Kontinuumsmechanik ist durch das Geschwindigkeitsfeld der Strömung an der Wand bestimmt, das nicht identisch mit dem Geschwindigkeitsfeld der Oberfläche des Rechennetzes sein muss. In dem Modell der Kontinuumsmechanik besteht eine Haftbedingung für eine viskose Strömung an einer festen Wand. Das Geschwindigkeitsfeld der Strömung an der Wand muss dem Geschwindigkeitsfeld der Wandbewegung entsprechen, jedoch nicht mit dem Geschwindigkeitsfeld der Oberfläche des Rechennetzes identisch sein. Es sollte lediglich gewährleistet sein, dass die Relativgeschwindigkeit keine Komponente senkrecht zu der Oberfläche des Rechennetzes besitzt. Dies ist der Fall, wenn die Relativgeschwindigkeit verschwindet und die Bewegung des Fluides an der Wand identisch mit der Bewegung der Oberfläche des Rechennetzes ist oder wenn eine Gleitbewegung zwischen dem Fluid an der Wand und der Oberfläche des Rechennetzes stattfindet.

Diese schwächere Form der Kopplung wird bei gleitenden Wänden ausgenutzt. Für die Bestimmung der Profileigenschaft wird ein ebener Strömungszustand vorausgesetzt. Für ein extrudiertes zweidimensionales Rechennetz eines Profilschnittes ist ein ebener Strömungszustand dadurch bestimmt, dass die Gradienten der Zustandsgrößen und der Normalenvektor der Profiloberfläche keine Komponenten senkrecht zu der Schnittebene besitzen. Für ein zweidimensionales Rechennetz sind die Voraussetzungen aufgrund der Definition erfüllt. Ein ebener Strömungszustand für ein extrudiertes zweidimensionales Rechennetz ist außer mit Symmetrierandbedingungen für die Ränder parallel zu der Schnittebene auch mit einer translatorisch periodischen Fortsetzung des Strömungsfelds in Normalenrichtung der Schnittebene kompatibel. Im Gegensatz zu Symmetrierandbedingungen erlaubt eine translatorisch periodische Fortsetzung auch Komponenten der Strömungsgeschwindigkeit in Normalenrichtung der Schnittebene und damit das Geschwindigkeitsfeld der Wandbewegung eines rotierenden Profilschnittes.

Um Übergeschwindigkeiten zu vermeiden, wird das Geschwindigkeitsfeld der Wandbewegung eines rotierenden Profilschnittes in das Geschwindigkeitsfeld in der Schnittebene und das Geschwindigkeitsfeld senkrecht zu der Schnittebene aufgeteilt. Das Geschwindigkeitsfeld in der Schnittebene entspricht dem Geschwindigkeitsfeld einer Translationsbewegung. Da bei einem Profil endlicher Dicke die Relativgeschwindigkeit einer Translationsbewegung der Wand gegenüber der Profiloberfläche des Rechennetzes niemals für alle Normalenrichtungen tangential zu der Oberfläche stehen kann, muss die Relativgeschwindigkeit verschwinden, was bedeutet, dass die Gitterbewegung des Rechennetzes der Translationsbewegung der Wand in der Schnittebene entspricht. In Normalenrichtung der Schnittebene steht jedes Geschwindigkeitsfeld tangential zu der Profiloberfläche, da die Normalenvektoren der Profiloberfläche in der Schnittebene liegen. Dies wird ausgenutzt, indem normal zu der Schnittebene keine Gitterbewegung stattfindet, und das Geschwindigkeitsfeld der Wandbewegung des rotierenden Profilschnittes in Normalenrichtung der Schnittebene nur für die Strömungsgeschwindigkeit an der Wand gesetzt wird. Entsprechend der Anströmgeschwindigkeit des Profilkörpers in axialer Richtung, dessen Vektor in der Schnittebene liegt, wird der Translationsgeschwindigkeit infolge der Rotationsbewegung des Profilkörpers eine Translationsgeschwindigkeit überlagert, sodass die Relativgeschwindigkeit in der Schnittebene einer gegebenen Anströmgeschwindigkeit und einem gegebenen Anstellwinkel der Profilsehne gegenüber dem Vektor der Anströmgeschwindigkeit entspricht.

Für einen numerischen Strömungslöser für dreidimensionale Strömungen, beispielsweise den numerischen Strömungslöser Tau, werden für zweidimensionale Strömungsrechnungen standardmäßig zweidimensionale Rechennetze extrudiert, sodass ein Netz aus einer Schicht dreidimensionaler Elemente entsteht. Für die Berücksichtigung des Einflusses der Rotation werden für die Symmetrierandbedingungen für die Ränder parallel zu der Netzebene des zweidimensionalen Rechennetzes auf eine translatorisch periodische Randbedingung ersetzt, wofür lediglich die periodische Information dem Rechennetz hinzugefügt werden muss.

Mit dem erfindungsgemäßen Verfahren wurden die Auftriebs- und Widerstandskurven für die Profilschnitte des Saab Fairchild Sf-340 Modellpropellers berechnet. Es hat sich gezeigt, dass die numerische Strömungssimulation nach dem erfindungsgemäßen Verfahren unter Berücksichtigung der Rotation deutlich bessere Ergebnisse liefert als bei einer numerischen Strömungssimulation mit einer Parallelanströmung des Profilschnittes.

Mit dem erfindungsgemäßen Verfahren wird es somit möglich, Profilschnitte von aerodynamischen oder hydrodynamischen Profilkörpern hinsichtlich ihrer aerodynamischen oder hydrodynamischen Eigenschaften numerisch zu untersuchen, wobei der Einfluss der Rotation auf derartige rotierende Profilkörper mit berücksichtigt wird und so auch numerisch die Ergebnisse und Erkenntnisse von Himmelskamp (siehe oben) bestätigt werden können. Hierdurch entfallen aufwendige Versuche in Windkanälen, wobei eine Gesamtoptimierung des Profilkörpers bereits im Entwicklungsstadium vor dem Bau eines ersten Prototyps durchgeführt werden können. Hierdurch werden Entwicklungszeiten verkürzt und effizienter genutzt. Außerdem sinken die Kosten für die Entwicklung eines Profilkörpers, da nunmehr bereits vor dem ersten Bau eines Prototyps eine Gesamtoptimierung des Profils erfolgen kann und nicht erst danach.

Durch das numerische Messverfahren können somit aerodynamische oder hydrodynamische Eigenschaften eines Profilschnittes bestimmt werden, die nicht ohne die Hilfe von zusätzlichen Modellannahmen durch physikalische Messverfahren erlangt werden können. Unter dem numerischen Messen im Sinne der vorliegenden Erfindung wird das Ermitteln von strömungsbezogenen Eigenschaften ohne Messsensoren verstanden.

In einer vorteilhaften Ausführungsform setzt sich die Translationsgeschwindigkeit der Gitterbewegung des (extrudierten) zweidimensionalen Rechennetzes aus der Bahngeschwindigkeit der Rotationsbewegung in dem Abstand der Schnittebene zu der Drehachse und einer Bewegung in Richtung der Drehachse zusammen.

In einer weiteren vorteilhaften Ausführungsform werden die Geschwindigkeitskomponenten in Normalenrichtung der Schnittebene des Profilschnittes berücksichtigt, die sich aus dem Geschwindigkeitsfeld der Rotationsbewegung des Profilrandes ergeben. Die Geschwindigkeitskomponenten, die sich aus dem Geschwindigkeitsfeld der Rotationsbewegung des Randes ergeben, werden durch die Viskosität einer reibungsbehafteten Strömung in das Strömungsfeld um den Rand mehr oder weniger übertragen, und diese Komponenten werden mitberücksichtigt, so dass das Geschwindigkeitsfeld nicht nur die Komponenten der Wandbewegung umfasst. Für die Punkte des Profilrandes ergeben sich jeweils unterschiedliche Abstände zu der Drehachse, wodurch sich die Geschwindigkeitsvektoren über den gesamten Rand verändern. Durch die Änderung der Geschwindigkeitsvektoren auf dem Rand ergibt sich auch eine Änderung der Komponenten in Normalenrichtung der Schnittebene, die mit zunehmendem Abstand von der Ebene senkrecht zu der Schnittebene durch die Drehachse zunehmen.

Vorteilhafter Weise werden ein Auftriebsbeiwert, ein Widerstandsbeiwert, ein Momentbeiwert, eine Auftriebskurve (Auftriebsbeiwert über dem Anstellwinkel), eine Widerstandskurve (Widerstandsbeiwert über dem Anstellwinkel), eine Polare (Auftriebsbeiwert über dem Widerstandsbeiwert mit dem Anstellwinkel als Parameter) und/oder eine Momentkurve (Momentbeiwert über dem Anstellwinkel) als strömungsbezogene Eigenschaften des Profilschnittes numerisch gemessen.

Bei den rotierenden, aerodynamischen umströmbaren Profilkörpern, deren Profilschnitte untersucht werden sollen, kann es sich beispielsweise um ein Propellerblatt, Rotorblatt, Impellerblatt oder Repellerblatt handeln. Dabei kommen insbesondere Profilkörper von Hubschraubern, Windkraftanlagen, Turbinen, Propellerflugzeugen sowie Impellern in Betracht.

In einer weiteren vorteilhaften Ausführungsform wird der rotierende, fluidumströmbare Profilkörper in eine oder mehrere Profilschnitte zerlegt, wobei für jeden Profilschnitt ein oder mehrere strömungsbezogene Eigenschaften ermittelt werden und wobei ein oder mehrere strömungsbezogene Eigenschaften des rotierenden, fluidumströmbaren Profilkörpers aus den jeweiligen strömungsbezogenen Eigenschaften der einzelnen Profilschnitte ermittelt werden. Demzufolge lassen sich aus den strömungsbezogenen Eigenschaften der einzelnen Profilschnitte, die mit Hilfe des vorliegenden erfindungsgemäßen Verfahren numerisch vermessen wurden, die strömungsbezogenen Eigenschaften des gesamten Profilkörpers ableiten und so beispielsweise Auftriebs- , Widerstands- und/oder Momentkurven des Profilkörpers ermitteln.

Die Aufgabe wird im Übrigen auch mit der Messvorrichtung gemäß Anspruch 9 erfindungsgemäß gelöst, wobei die Messvorrichtung eine Datenverarbeitungsanlage umfasst, auf der eine numerische Strömungssimulation ausführbar ist, die die zuvor genannten Eigenschaften aufweist. Der Messvorrichtung werden dann die Geometriedaten des jeweiligen Profilschnittes, der Abstand der Schnittebene von der Drehachse, die Winkelgeschwindigkeit der Drehung und der Einstellwinkel der Profilsehne gegenüber einer Ebene senkrecht zu der Drehachse übermittelt, wobei dann die auf der Messvorrichtung ausgeführte numerische Strömungssimulation die entsprechenden strömungsbezogenen Eigenschaften berechnet.

Die Erfindung wird anhand der beigefügten Figuren beispielhaft erläutert.

Es zeigen:

Figur 1    - schematische Darstellung der erfindungsgemäßen Messvorrichtung;

Figur 2    - schematische Darstellung des Geschwindigkeitsfeldes eines angestellten Profilschnittes endlicher Ausdehnung in der Projektion auf eine Ebene senkrecht zu der Drehachse;

Figur 3    - schematische Darstellung der Komponenten der massenspezifischen Trägheitskräfte auf dem Rand des Profilschnittes in der Schnittebene projiziert auf die Profilsehne.

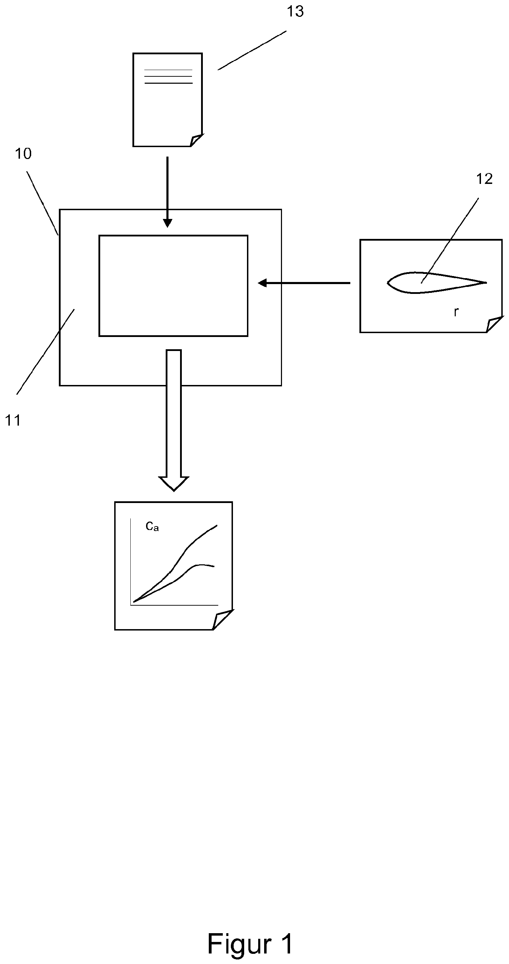

Figur 1 zeigt die Messvorrichtung 10, die als Datenverarbeitungsanlage ausgebildet ist und auf der eine numerische Strömungssimulation 11 ausgeführt beziehungsweise ausführbar ist. Als Eingabedaten erhält die numerische Strömungssimulation der Messvorrichtung 10 zunächst die Form des Profilschnitts 12 des zu untersuchenden Profilkörpers, den Radius $r_n$, der den Abstand der Schnittebene des Profilschnittes von der Drehachse des rotierenden Profilkörpers beschreibt, die Winkelgeschwindigkeit $\Omega$ der Drehung sowie den Einstellwinkel $\beta$ der Profilsehne gegenüber einer Ebene senkrecht zu der Drehachse.

Des Weiteren erhält die numerische Strömungssimulation 11 weitere Eingabedaten 13, die Grundlage der numerischen Strömungssimulation werden sollen. Dies kann beispielsweise die Anströmgeschwindigkeit sowie die Abstufung der zu untersuchenden Anstellwinkel sein.

Die numerische Strömungssimulation berechnet nun beispielsweise die Auftriebskurve des Profils, die den Auftriebsbeiwert $c_a$ in Abhängigkeit des Anstellwinkels $\alpha$ der Profilsehne gegenüber dem Vektor der Anströmgeschwindigkeit darstellt. Hierzu wird zunächst für einen konkreten Anstellwinkel $\alpha$ die numerische Strömungssimulation ausgeführt und es werden die strömungsbezogene (aerodynamische) Beiwerte des Profilschnitts ermittelt. Die strömungsbezogene (aerodynamische) Beiwerte können beispielsweise der Auftriebsbeiwert $c_a$, der Widerstandsbeiwert $c_w$ oder der Momentenbeiwert $c_m$ sein. Für verschiedene Anstellwinkel $\alpha$ ergeben sich daraus die Auftriebskurve, die Widerstandskurve und der Momentenkurve.

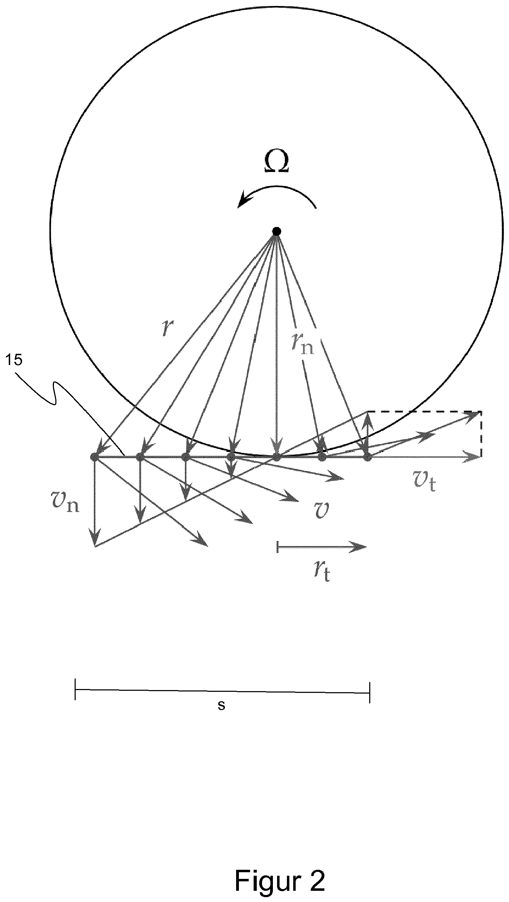

Für eine Schnittebene, die mit dem Abstand $r_n$ zu der Drehachse mit der konstanten Winkelgeschwindigkeit $\Omega$ rotiert, ist in Figur 2 das Geschwindigkeitsfeld der Rotationsbewegung des Randes in der Projektion auf eine Ebene senkrecht zu der Drehachse dargestellt. Das Geschwindigkeitsfeld ist relativ zu der Schnittebene zeitlich konstant. Für eine verschwindende Ausdehnung s des Profilschnittes in der Ebene senkrecht zu der Drehachse liegt das Geschwindigkeitsfeld in der Schnittebene und ist auch räumlich konstant; es entspricht einer Translationsbewegung des Randes mit dem Vektor $v_t$ der Bahngeschwindigkeit auf der Kreisbahn mit dem Abstand $r_n$ zu der Drehachse.

Für eine endliche Ausdehnung s des Profils in der Ebene senkrecht zu der Drehachse überlagert sich dem Geschwindigkeitsfeld der Translationsbewegung mit der Bahngeschwindigkeit $v_t$ ein zeitlich konstantes Geschwindigkeitsfeld, das senkrecht auf der Profilebene steht und linear mit dem Abstand $r_t$ zu der Ebene senkrecht zu der Profilebene durch die Drehachse skaliert. Für die Berechnung der Auftriebs- und Widerstandskurve des Profils ohne eine Berücksichtigung des Einflusses der Rotation wird die Ausdehnung s des Profilschnittes in der Ebene senkrecht zu der Drehachse vernachlässigt und die Auftriebs- und Widerstandskurven werden mit einer Parallelanströmung berechnet, deren Geschwindigkeit der entgegengesetzt orientierten Bahngeschwindigkeit $-v_t$ in der Schnittebene entspricht, die bei einer Vorwärtsbewegung in Richtung der Drehachse um eine entsprechende Komponente ergänzt werden kann.

Um ein numerisches Verfahren für die Berücksichtigung des Einflusses der Rotation zu erhalten, wird eine Formulierung der Bilanzgleichungen des Modells der Kontinuumsmechanik für rotierende Rechennetze verwendet, die in Kroll, N.: "Berechnung von Strömungsfeldern um Propeller und Rotoren im Schwebeflug durch die Lösung der Euler-Gleichungen", Dissertation, Fakultät für Maschinenbau und Elektrotechnik, Technische Universität Carolo-Wilhelmina zu Braunschweig, 1989, entwickelt wurde und die in dem numerischen Strömungslöser Tau verwendet wird, um dreidimensionale Strömungen um rotierende Profilkörper zu berechnen. Bei dieser Formulierung findet keine Aufteilung der Strömungsgeschwindigkeit v im Inertialsystem in eine Relativgeschwindigkeit gegenüber einem rotierenden Bezugssystem und eine Geschwindigkeit des rotierenden Bezugssystems gegenüber dem Inertialsystem statt, stattdessen wird die Änderung der Strömungsgeschwindigkeit des Inertialsystems gegenüber einem rotierenden Bezugssystem betrachtet. Normalerweise erfolgt eine Zerlegung eines Ortsvektors r im Inertialsystem in den Ortsvektor ro zu dem Ursprung des rotierenden Bezugssystems und den Ortsvektor $r_r$ vom Ursprung zu einem Punkt des rotierenden Bezugssystems, das eine Drehbewegung ausführt, dessen Lageänderung zu einem Zeitpunkt to durch die Transformationsmatrix T beschriebe wird

$$r = r_0 + Tr_{\mathrm{r}}\,.$$

Durch die Ableitung dieser Beziehung nach der Zeit erhält man die Relativgeschwindigkeiten

$$\frac{\partial r}{\partial t} = \frac{\partial r_0}{\partial t} + \underbrace{\frac{\partial T}{\partial t}}_{\Omega\times} r_{\mathrm{r}} + \underbrace{T}_{I} \frac{\partial r_{\mathrm{r}}}{\partial t}\,.$$

In den Bilanzgleichungen wird die Ableitung zu dem jeweils aktuellen Zeitpunkt $t_0 = O$ betrachtet, bei dem aufgrund der Drehung noch keine Lageänderung auftritt. In diesem Fall ist die Transformationsmatrix T für die Drehung identisch mit der Einheitsmatrix I und das Matrix-Vektorprodukt mit der Zeitableitung der Transformationsmatrix T für die Drehung lässt sich als Kreuprodukt mit dem Vektor der Winkelgeschwindigkeit $\Omega$ darstellen. Durch eine weitere Ableitung dieser Beziehung nach der Zeit t erhält man die Zentripetal- und die Coriolis-Beschleunigung, die sich auf den Ortsvektor $r_r$ und die Geschwindigkeit $v_r = dr_r/dt$ in dem rotierenden Bezugssystem beziehen. Bei der alternativen Formulierung wird auf die Aufteilung der Strömungsgeschwindigkeit v im Intertialsystem verzichtet und nur deren zeitliche Änderung gegenüber dem rotierenden Bezugssystem betrachtet. Setzt man den Geschwindigkeitsvektor v in die Beziehung der oben genannten Formel ein, so erhält man

$$\frac{\partial v}{\partial t} = \underbrace{\frac{\partial T}{\partial t}}_{\Omega\times} v + \underbrace{T}_{I} \frac{\partial v}{\partial t}\,.$$

sodass als einziger zusätzlicher Term die Relativbeschleunigung $\Omega \times v$ entsteht. Das Produkt der Relativbeschleunigung $\Omega \times v$ mit der Dichte $\rho$ entsteht bei der Zeitableitung des Volumenintegrals auf der linken Seite der Impulsgleichung, die als vektorielle Gleichung drei skalare Gleichungen für die drei Raumrichtungen beinhaltet. Bringt man diesen Term auf die rechte Seite der Impulsgleichungen kann man ihn mit negativen Vorzeichen als Volumenspezifische Trägheitskraft interpretieren.

Bewegt sich ein Profil durch eine reibungsfreie Strömung, die gegenüber dem Inertialsystem ruht, ist der zusätzliche Beschleunigungsterm $\Omega \times v$ identisch null und die Rotation hat keinen Einfluss, wenn die Strömungsgeschwindigkeit infolge der Verdrängung vernachlässigt wird.

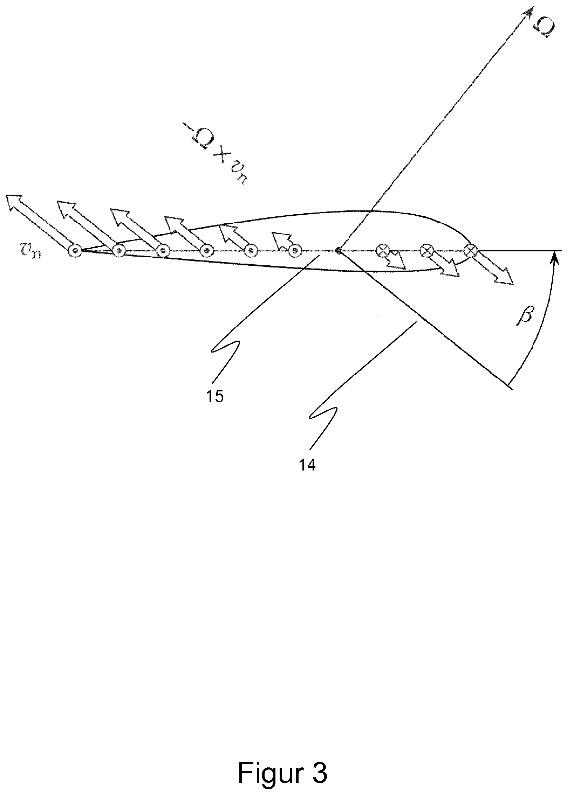

Eine massenspezifische Trägheitskraft in dem rotierenden Bezugssystem ist gleich der negativen Relativbeschleunigung $-\Omega \times v$. Figur 3 zeigt die Schnittebene des Profilschnittes und die Projektion der Drehachse auf die Schnittebene. Die massenspezifischen Trägheitskräfte, die auf dem Rand des Profilschnittes wirken, sind in Figur 3 in der Projektion auf die Profilsehne dargestellt. Die massenspezifischen Trägheitskräfte verschwinden in den Schnittpunkten des Randes mit der Ebene senkrecht zu der Schnittebene durch die Drehachse und skalieren linear mit dem Abstand rt zu dieser Ebene. Vor dieser Ebene entstehen bremsende und hinter dieser Ebene beschleunigende massenspezifische Trägheitskräfte. Die Massenspezifischen Trägheitskräfte besitzen den Einstellwinkel $\beta$ gegenüber der Profilsehne, der identisch ist mit dem Einstellwinkel der Profilsehne gegenüber einer Ebene senkrecht zu der Drehachse.

Die massenspezifischen Trägheitskräfte wirken in der Schnittebene in der Grenzschicht der Strömung. Die Grenzschicht der Strömung stellt eine dünne Schicht in der Nähe des Randes des Profilschnittes dar, in dem viskose Kräfte eine Rolle spielen. Die Trägheitskräfte in der Schnittebene entstehen durch das Geschwindigkeitsfeld der Rotationsbewegung des Randes in Normalenrichtung der Schnittebene, das sich in das Strömungsfeld der Grenzschicht durch viskosen Kräfte fortpflanzt. In Figur 3 sind in der Projektion der massenspezifischen Trägheitskräfte des Randes auf die Profilsehne die Normalenkomponenten der Strömungsgeschwindigkeit dargestellt. Ein Kreuz zeigt entsprechend einer Pfeilfinne an, dass die Geschwindigkeitskomponenten normal zu der Profilebene weg vom Betrachter gerichtet sind; ein Punkt zeigt entsprechend einer Pfeilspitze an, dass die Geschwindigkeitskomponenten normal zu der Profilebene zum Betrachter hin gerichtet sind. Die Zeichenebene entspricht der Schnittebene.

Die Trägheitsterme, die bisher für die Berechnung einer dreidimensionalen Umströmung eines rotierenden Profilkörpers mit einem rotierenden Rechennetz verwendet wurden, werden für die Berechnung einer ebenen Umströmung eines Profilschnittes mit einem nicht rotierenden zweidimensionalen extrudierten Rechennetz verwendet. Die sich aus dem Geschwindigkeitsfeld normal zu der Schnittebene ergebenden Trägheitskräfte in der Schnittebene, wie sie Figur 3 zeigt, sind für eine korrekte Darstellung des Einflusses der Rotation und die sich daraus ergebenden strömungsbezogenen Eigenschaften verantwortlich. Die Trägheitskräfte besitzen im hinteren Teil des Profilschnittes eine Komponente in Strömungsrichtung, welche der Verzögerung der Grenzschicht infolge des Druckanstiegs entgegenwirkt und damit eine vorzeitige Ablösung der Strömung verhindert. Im vorderen Teil des Profilschnittes besitzen die Trägheitskräfte eine Komponente entgegen der Strömungsrichtung, welche der Beschleunigung der Grenzschicht infolge der Verdrängung der Strömung und des damit verbundenen Druckabfalls entgegenwirkt. Da die Strömung in diesem Bereich stark beschleunigt wird, führen die Komponenten entgegen der Strömungsrichtung zu keiner Ablösung der Strömung. Durch die Berücksichtigung der Trägheitskräfte eines dreidimensionalen Strömungsfeldes bei der Berechnung einer ebenen Profilumströmung, bei der Geschwindigkeitskomponenten in allen Raumrichtungen vorhanden sind, werden auch Sekundäreffekte der Trägheitskräfte in der Grenzschicht berücksichtigt.

**Bezugszeichenliste**

10 Messvorrichtung
11 numerische Strömungssimulation
12 Profilschnitt
13 Eingabedaten
14 Ebene senkrecht zu der Drehachse
15 Profilsehne

**Patentansprüche**

1. Verfahren zum numerischen Messen mindestens einer strömungsbezogenen Eigenschaft eines Profilschnittes (12) eines rotierenden, fluidumströmbaren Profilkörpers mittels einer auf einer Datenverarbeitungsanlage ablaufenden numerischen Strömungssimulation (11), die eine fluidbasierte Umströmung des Profilsschnittes (12) mittels mehrdimensionaler Rechennetze berechnet, **dadurch gekennzeichnet, dass** das Verfahren die folgenden Schritte umfasst:

   - Bereitstellen einer auf einer Datenverarbeitungsanlage ausführbaren numerischen Strömungssimulation (11), die derart eingerichtet ist, dass

      ◦ die Strömungsgeschwindigkeit des Fernfeldes der numerischen Strömungssimulation (11) auf null gesetzt ist und stattdessen eine Gitterbewegung des mehrdimensionalen Rechennetzes mit einer Translationsgeschwindigkeit in der Profilschnittebene ausgeführt wird, so dass die Relativgeschwindigkeit die Anströmgeschwindigkeit des Profilschnittes (12) unter einem gegebenen Anstellwinkel ergibt,

◦ die Symmetrierandbedingungen für die Ränder des mehrdimensionalen Rechennetzes auf eine translatorisch periodische Randbedingung gesetzt sind, und

◦ in den Trägheitstermen der Bilanzgleichungen der numerischen Strömungssimulation (11) die aus dem Geschwindigkeitsfeld der Drehbewegung auf dem Rand des Profilschnittes (12) resultierende Geschwindigkeitskomponente in Normalenrichtung der Profilschnittebene berücksichtigt werden,

- Ausführen der wie zuvor bereitgestellten numerischen Strömungssimulation (11), um die mindestens eine strömungsbezogene Eigenschaft des Profilschnittes (12) numerisch zu messen und zu erhalten.

**2.** Verfahren nach Anspruch 1, **dadurch gekennzeichnet, dass** die mindestens eine strömungsbezogene Eigenschaft eine aerodynamische Eigenschaft eines rotierenden, aerodynamisch umströmbaren Profilkörpers oder eine hydrodynamische Eigenschaft eines rotierenden, hydrodynamisch umströmbaren Profilkörpers ist.

**3.** Verfahren nach Anspruch 1 oder 2, **dadurch gekennzeichnet, dass** sich die Translationsgeschwindigkeit der Gitterbewegung aus einer Bahngeschwindigkeit der Rotationsbewegung in dem Abstand der Profilschnittebene zu der Drehachse und einer Bewegung in Richtung der Drehachse zusammensetzt.

**4.** Verfahren nach einem der vorhergehenden Ansprüche, **dadurch gekennzeichnet, dass** für die numerische Strömungssimulation (11) ein zweidimensionales Rechennetz verwendet wird, welches in Normalenrichtung der Rechennetzebene extrudiert ist, so dass ein Rechennetz aus einer Schicht dreidimensionaler Elemente gebildet wird.

**5.** Verfahren nach einem der vorhergehenden Ansprüche, **dadurch gekennzeichnet, dass** entlang der Profilsehne des Profilschnittes (12) eine Mehrzahl von Geschwindigkeitskomponenten in Normalenrichtung der Profilschnittebene berücksichtig werden, die sich aus dem Geschwindigkeitsfeld über die Profilsehne ergeben.

**6.** Verfahren nach einem der vorhergehenden Ansprüche, **dadurch gekennzeichnet, dass** aus den aus dem Geschwindigkeitsfeld der Drehbewegung auf dem Rand des Profilschnittes (12) resultierende Geschwindigkeitskomponente in Normalenrichtung der Profilschnittebene mindestens eine volumenspezifische Trägheitskraft berechnet wird, die in den Trägheitstermen der Bilanzgleichung berücksichtigt wird.

**7.** Verfahren nach einem der vorhergehenden Ansprüche, **dadurch gekennzeichnet, dass** ein Auftriebsbeiwert, ein Widerstandsbeiwert, ein Momentbeiwert, eine Auftriebskurve, eine Widerstandskurve, eine Polare, und/oder eine Momentkurve als strömungsbezogene Eigenschaften des Profilschnittes (12) numerisch gemessen werden.

**8.** Verfahren nach einem der vorhergehenden Ansprüche, **dadurch gekennzeichnet, dass** der rotierende, fluidumströmbare Profilkörper ein Propellerblatt, ein Rotorblatt, ein Impellerblatt, ein Repellerblatt oder das Blatt einer Schiffsschraube ist.

**9.** Verfahren nach einem der vorhergehenden Ansprüche, **dadurch gekennzeichnet, dass** der rotierende, fluidumströmbare Profilkörper in eine Mehrzahl von einzelnen Profilschnitten (12) zerlegt wird, wobei für jeden Profilschnitt (12) mindestens eine strömungsbezogene Eigenschaft ermittelt wird und wobei mindestens eine strömungsbezogene Eigenschaft des rotierenden, fluidumströmbaren Profilkörpers aus den jeweiligen strömungsbezogenen Eigenschaften der einzelnen Profilschnitte (12) ermittelt wird.

**10.** Messvorrichtung (10) zum numerischen Messen mindestens einer strömungsbezogenen Eigenschaft eines Profilschnittes (12) eines rotierenden, fluidumströmbaren Profilkörpers, wobei die Messvorrichtung (10) eine Datenverarbeitungsanlage umfasst, auf der eine numerische Strömungssimulation (11) ausführbar ist, die eine fluidbasierte Umströmung des Profilsschnittes mittels mehrdimensionaler Rechennetze berechnet, **dadurch gekennzeichnet, dass** die numerischen Strömungssimulation (11), die derart eingerichtet ist, dass

- die Strömungsgeschwindigkeit des Fernfeldes der numerischen Strömungssimulation (11) auf null gesetzt ist und stattdessen eine Gitterbewegung des mehrdimensionalen Rechennetzes mit einer Translationsgeschwindigkeit in der Profilschnittebene ausgeführt wird, so dass die Relativgeschwindigkeit die Anströmgeschwindigkeit des Profilschnittes (12) unter einem gegebenen Anstellwinkel ergibt,

- die Symmetrierandbedingungen für die Ränder des mehrdimensionalen Rechennetzes auf eine translatorisch periodische Randbedingung gesetzt sind, und

- in den Trägheitstermen der Bilanzgleichungen der numerischen Strömungssimulation (11) die aus dem Geschwindigkeitsfeld der Drehbewegung auf dem Rand des Profilschnittes (12) resultierende Geschwindigkeitskomponente in Normalenrichtung der Profilschnittebene berücksichtigt werden.

11. Messvorrichtung (10) nach Anspruch 10, **dadurch gekennzeichnet, dass** die Messvorrichtung (10) zur Durchführung des Verfahrens nach einem der Ansprüche 1 bis 9 ausgebildet ist.

12. Computerprogramm mit Programmcodemitteln eingerichtet zur Durchführung einer numerischen Strömungssimulation (11) nach einem der Ansprüche 1 bis 9, wenn das Computerprogramm auf einer Datenverarbeitungsanlage ausgeführt wird.

Figur 1

Figur 2

Figur 3

**Europäisches Patentamt**
**European Patent Office**
**Office européen des brevets**

# EUROPÄISCHER RECHERCHENBERICHT

**Nummer der Anmeldung**

EP 19 19 5130

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | Axel Raichle: "Flusskonservative Diskretisierung des Wirkscheibenmodells als Unstetigkeitsfläche" In: "DLR-Forschungsbericht, Dissertation", 31. August 2017 (2017-08-31), Deutsches Zentrum für Luft- und Raumfahrt, XP055659171, Seite 225, * das ganze Dokument * * Seite 145, Absatz 2 * * Seite 149, Absatz 2 - Absatz 4 * * Abbildung 6.17(b) * * Abbildungen 6.18,6.19 * * Seite 167, Absatz 2 * * Abbildung 7.9 * ----- | 1-12 | INV. G06F30/28 |
| A | CARLO E CARCANGIU ET AL: "CFD-RANS analysis of the rotational effects on the boundary layer of wind turbine blades", JOURNAL OF PHYSICS: CONFERENCE SERIES, Bd. 75, 28. August 2007 (2007-08-28), Seiten 1-9, XP020125104, DOI: 10.1088/1742-6596/75/1/012031 * das ganze Dokument * * Zusammenfassung * * Introduction; Seite 1 - Seite 3 * * Seite 6, Absatz 2 - Absatz 3 * * Seite 8, Absatz 2 - Absatz 3 * * Abbildung 9 * ----- | 1-12 | |

**RECHERCHIERTE SACHGEBIETE (IPC)**

G06F

Der vorliegende Recherchenbericht wurde für alle Patentansprüche erstellt

| Recherchenort | Abschlußdatum der Recherche | Prüfer |
|---|---|---|
| München | 30. Januar 2020 | Rungger, Matthias |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- Profile investigations on a Rotating Airscrew. **HIMMELSKAMP, H.** Reports and Translations No 832, AVA 45 A 20. Aerodynamische Versuchsanstalt, 1947

- Berechnung von Strömungsfeldern um Propeller und Rotoren im Schwebeflug durch die Lösung der Euler-Gleichungen. **KROLL, N.** Dissertation, Fakultät für Maschinenbau und Elektrotechnik. Technische Universität Carolo-Wilhelmina zu Braunschweig, 1989